# DEMANDE DE BREVET EUROPEEN

(11) **EP 2 339 615 A1**
(43) Date de publication de la demande: **29.06.2011**
(21) Numéro de dépôt: 10192594.9
(22) Date de dépôt: 25.11.2010
(51) Int. Cl.: H01L 21/762

(54) **Procédé de réalisation d'une hétérostructure avec minimisation de contrainte**

(30) Priorité: 23.12.2009 FR 0959473
(71) Demandeur: S.O.I. Tec Silicon on Insulator Technologies, 38190 Bernin (FR)
(72) Inventeur: Vaufredaz, Alexandre, 38140, La Murette (FR)
(74) Mandataire: Desormiere, Pierre-Louis

(57) **Abrégé**

Procédé de réalisation d'une hétérostructure comprenant une étape de collage (S5) d'une première plaque (110) sur une deuxième plaque (120), la première plaque (110) ayant un coefficient de dilatation thermique inférieur au coefficient de dilatation thermique de la deuxième plaque (120) et au moins une étape de recuit de renforcement de collage (S7). Le procédé est notamment **caractérisé en ce qu**'il comprend, après l'étape de collage (S5) et avant l'étape de recuit de renforcement de collage (S7), au moins une étape de détourage au moins partiel (S5) de la première plaque (110).

## Description

La présente invention concerne la réalisation de structures hétérogènes formées par collage d'une première plaque ("wafer") ou substrat sur une deuxième plaque ou substrat, la première plaque ayant un coefficient de dilatation thermique inférieur au coefficient de dilatation thermique de la deuxième plaque. De telles hétérostructures sont utilisées notamment en microélectronique ou en optoélectronique. L'invention s'applique notamment dans le cas de fabrication d'hétérostructures du type silicium sur saphir (AL₂O₃) connues sous l'acronyme SOS (pour "Silicon-On-Sapphire").

Lors de l'assemblage de deux plaques ayant des coefficients de dilatation thermique différents, par exemple différents d'au moins 10% ou 20% à température ambiante (20°C), ou lors de tout traitement ultérieur des deux plaques assemblées, des phases de montée en température peuvent avoir lieu, par exemple pour renforcer l'interface de collage dans le cadre d'un recuit de renforcement de collage.

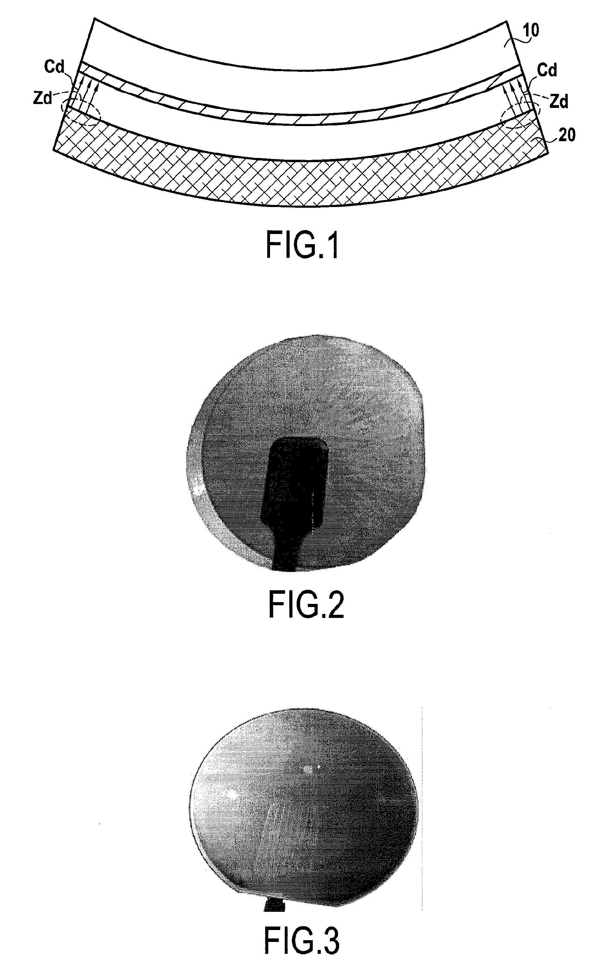

La figure 1 illustre le comportement d'une hétérostructure lors d'un recuit de renforcement de collage réalisé à une température d'environ 160°C, l'hétérostructure étant formé par collage d'une première plaque ou substrat 10 correspondant à une structure SOI (Silicium sur Isolant) sur une deuxième plaque ou substrat 20 en saphir. Comme illustrée sur la figure 1, la différence de coefficient de dilatation thermique (CTE) entre le silicium, principal composant de la structure SOI, et le saphir (CTE Si < CTE AL₂O₃) conduit, lors d'un traitement thermique, à une déformation de l'assemblage telle que des contraintes de décollement Cd importantes sont appliquées au niveau de zones Zd situées au niveau des bords de l'hétérostructure.

En raison de ces contraintes, le transfert en bord de plaque est insuffisant, ce qui conduit à l'apparition d'une couronne (zone non transférée de la première plaque sur la deuxième plaque) trop large et irrégulière pouvant notamment entraîner un écaillage en bord de plaques.

Dans le cas de structures hétérogènes telles que les hétérostructures SOS, ces dernières sont réalisées par assemblage d'une structure, par exemple une structure SOI, sur une plaque ou substrat support tel qu'un substrat en saphir. Dans ce cas, la réalisation de l'hétérostructure SOS comprend un collage par adhésion moléculaire (en anglais "direct wafer bonding" ou "fusion bonding") de la structure SOI sur la plaque de saphir, un recuit de renforcement ou de stabilisation de collage, et un amincissement de la structure SOI pour former une couche transférée de silicium sur la plaque de saphir. L'amincissement est typiquement réalisé en deux étapes, à savoir une première étape de meulage permettant de retirer la majeure partie du substrat support de la structure SOI suivie d'une seconde étape de gravure chimique jusqu'à la couche d'oxyde de la structure SOI qui joue le rôle de couche d'arrêt. La gravure chimique est réalisée typiquement avec une solution TMAH (Tetramethylammonium hydroxide).

La génération de contraintes de décollement en bord de substrats comme expliqué ci-avant peut entraîner un décollement sur les bords entre la couche de silicium et le substrat en saphir qui permet à la solution de gravure de s'infiltrer au niveau de l'interface de collage lors de l'amincissement. Cette infiltration affaiblit encore le collage et peut entraîner la délamination de la structure comme montrée sur la figure 2 où l'on observe une délamination de la couche superficielle de silicium et du substrat ou plaque de saphir sous-jacent lorsque l'on applique un effort de cisaillement à la couche de silicium.

Enfin comme représentés sur la figure 3, des défauts de type "edge loss" (élargissement de la couronne dû à la délamination) sont déjà présents à l'issue du meulage. Les défauts de type "edge loss" sont dus à la délamination lors du recuit de renforcement de collage et sont d'autant plus larges que l'épaisseur de silicium présente au moment du recuit de renforcement du collage est importante.

### Résumé de l'invention

Un des buts de l'invention est de remédier aux inconvénients précités en proposant une solution permettant de réaliser une hétérostructure par collage d'une première plaque ou substrat sur une deuxième plaque ou substrat, la première plaque ayant un coefficient de dilatation thermique inférieur au coefficient de dilatation thermique de la deuxième plaque, et ce en limitant le décollement et l'apparition de défauts en bord de substrats comme décrits ci-avant.

A cet effet, la présente invention propose un procédé de réalisation d'une telle hétérostructure dans lequel on procède, après le collage et avant le recuit de renforcement de collage, à un détourage au moins partiel de la première plaque.

Le détourage au moins partiel de la première plaque permet de diminuer l'épaisseur de cette dernière en périphérie et, par conséquent, l'importance des contraintes de décollement dues à la différence de coefficients de dilatation thermique entre les deux plaques. On améliore ainsi la largeur et la régularité de la couronne, c'est-à-dire la zone non transférée en bord de substrats.

Selon un mode de mise en oeuvre du procédé de l'invention, on réalise une seule étape de détourage après laquelle la première plaque présente au niveau sa portion détourée une épaisseur inférieure ou égale à 55 µm et une seule étape de recuit de renforcement de collage réalisée à une température d'environ 160°C sur une durée d'environ 2 heures.

Selon un autre mode de mise en oeuvre du procédé de l'invention, le procédé comprend des première et deuxième étapes de recuit de renforcement de collage et des première et deuxième étapes de détourage au moins partiel de la première plaque. Dans ce mode, la première étape de détourage est réalisée après la première étape de recuit et avant la deuxième étape de recuit, tandis que la deuxième étape de détourage est réalisée après ladite deuxième étape de recuit.

Ce mode mise en oeuvre permet d'atteindre des profondeurs de détourage qui ne pourraient être atteintes en une seule étape de détourage sans risque d'écaillage ou de délamination des plaques.

En raison de la diminution partielle des contraintes de décollement grâce à la première étape de détourage, la deuxième étape de recuit de renforcement de collage peut être réalisée à une température supérieure à celle de la première étape de recuit de renforcement de collage.

Le procédé de l'invention est notamment applicable à la réalisation de structure de type SOS (Silicium sur Saphir), le procédé utilisant dans ce cas un substrat de silicium ou un substrat SOI comme première plaque et un substrat de saphir comme deuxième plaque.

Selon un aspect de l'invention, le procédé comprend en outre, après la ou les étapes de recuit de renforcement de collage, une étape d'amincissement de la première plaque, l'amincissement étant réalisé par meulage suivi d'une gravure de la première plaque. Le meulage est réalisé avec une roue dont la surface de travail comprend des particules abrasives d'une taille moyenne supérieure à 6,7 microns.

L'utilisation pour le meulage d'une roue ou meule comprenant des particules abrasives d'une taille moyenne supérieure à 6,7 microns permet de réaliser un meulage dit "grossier" ("coarse grinding") en comparaison avec un meulage fin ("fine grinding") réalisé avec une roue comportant des particules abrasives d'une taille moyenne inférieure à 6,7 microns.

La Déposante a choisi d'utiliser un tel meulage grossier car il permet d'amincir la première plaque en minimisant les risques de délamination entre les plaques pendant le meulage, le meulage réalisé avec des particules abrasives d'une taille moyenne au moins supérieure à 6,7 microns permet d'enlever une grande quantité de matière sans avoir à exercer une force d'appui trop importante. Lors du meulage, la force d'appui de la roue sur la première plaque n'excède pas 222,5 newtons. En revanche, avec des particules abrasives de taille inférieure correspondant à un meulage fin, le rapport de surface entre la roue fine et le matériau est plus important qu'entre la roue grossière et ce même matériau, ce qui a pour effet d'augmenter la force d'appui de la roue sur la première plaque et d'accroître, par conséquent, les risques de délamination.

### Brève description des figures

D'autres caractéristiques et avantages de l'invention ressortiront de la description suivante de modes particuliers de réalisation de l'invention, donnés à titre d'exemples non limitatifs, en référence aux dessins annexés, sur lesquels :
- la figure 1 est une vue schématique en coupe montrant les contraintes appliquées dans une hétérostructure de type SOS lors d'un traitement thermique de renforcement de collage,
- la figure 2 est une photographie montrant la délamination d'une hétérostructure silicium sur saphir,
- la figure 3 est une photographie montrant des défauts de type "edge loss" et de type cracks disposés en croix dans une hétérostructure silicium sur saphir après meulage,
- les figures 4A à 4H, sont des vues schématiques montrant la réalisation d'une hétérostructure mettant en oeuvre un procédé selon un mode de réalisation de l'invention,
- la figure 5 est un organigramme des étapes mises en oeuvre lors de la réalisation de l'hétérostructure illustrée dans les figures 4A à 4H,
- les figures 6A à 6I, sont des vues schématiques montrant la réalisation d'une hétérostructure mettant en oeuvre un procédé selon un autre mode de réalisation de l'invention,
- la figure 7 est un organigramme des étapes mises en oeuvre lors de la réalisation de l'hétérostructure illustrée dans les figures 6A à 6I.

### Exposé détaillé de modes de réalisation de l'invention

Le procédé de la présente invention s'applique d'une manière générale à la réalisation d'hétérostructures comprenant au moins deux plaques ayant respectivement des coefficients de dilatation thermiques différents (par exemple silicium sur saphir, silicium sur verre, etc.). Les plaques sont assemblées entre elles par adhésion moléculaire ou par tout autre type de collage tel que le collage anodique, métallique, ou avec adhésif. Les plaques se présentent sous la forme de tranches ou "wafers" au contour généralement circulaire et peuvent présenter différents diamètres, notamment des diamètres de 100 mm, 150mm, 200 mm ou 300 mm.

Des composants peuvent être préalablement formés dans une des plaques qui est ensuite collée sur l'autre plaque qui constitue un support. Ces composants correspondent notamment à des éléments formant tout ou partie d'un composant électronique ou d'une pluralité de microcomposants électroniques, tels que des circuits ou des contacts ou encore des couches actives.

Plus généralement, l'invention s'applique particulièrement à des structures assemblées ne pouvant pas subir de recuit de collage haute température, comme c'est le cas également des hétérostructures formés d'un assemblage de plaques présentant des coefficients de dilatation différents.

L'invention s'applique plus particulièrement, mais non exclusivement, à de hétérostructures de type SOS (silicium sur saphir) formée à partir d'un assemblage entre une première plaque ou substrat de saphir et une deuxième plaque ou substrat comprenant du silicium tel qu'une structure SOI.

Les hétérostructures comprenant une couche de silicium sur un substrat saphir présentent des avantages particuliers. Les structures SOS permettent la réalisation de dispositifs hautes fréquences à faible consommation d'énergie. L'utilisation de substrats en saphir permet en outre d'avoir une très bonne dissipation thermique supérieure à celle obtenue par exemple avec des substrats en quartz.

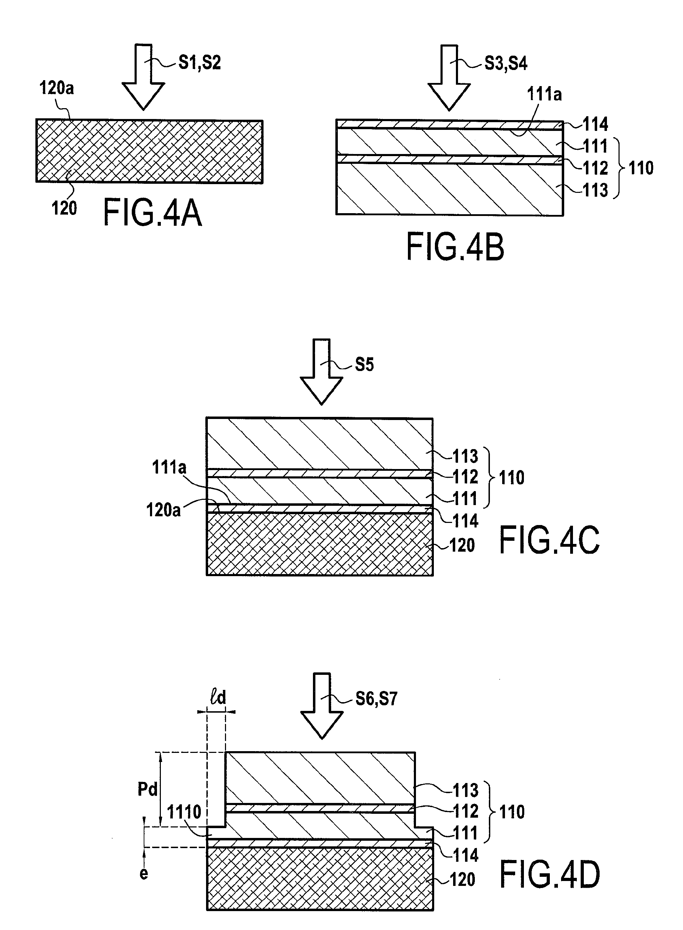

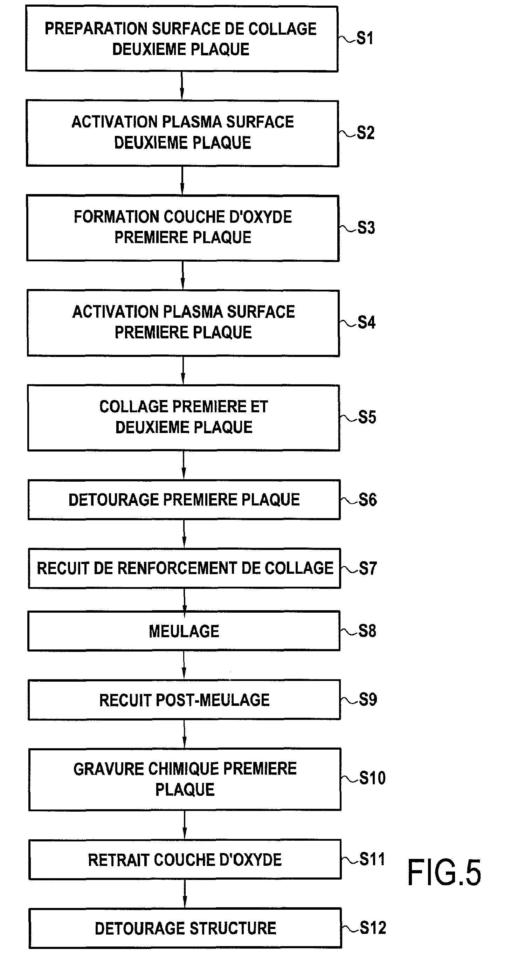

On décrit, en référence aux figures 4A à 4G et 5, un procédé de réalisation d'une hétérostructure de type SOS à partir d'une première plaque ou substrat initial 110 (Top) et d'une deuxième plaque ou substrat support 120 (Base).

Comme représentée sur la figure 4B, la première plaque 110 est constituée d'une structure de type SOI (Silicium sur Isolant) comprenant une couche de silicium 111 sur un support 113 également en silicium, une couche d'oxyde enterrée 112, par exemple en SiO₂, étant disposée entre la couche 111 et le support 113.

La deuxième plaque 120 est constituée d'une plaque ("wafer") de saphir (figure 4A).

Avant de procéder au collage de la première plaque 110 sur la deuxième plaque 120, la surface de collage 120a peut être préparée (étape S1). Cette préparation peut notamment consister en un nettoyage chimique réalisé notamment par un nettoyage RCA (à savoir la combinaison d'un bain SC1 (NH₄OH, H₂O₂, H₂O) adapté au retrait des particules et des hydrocarbures et d'un bain SC2 (HCl, H₂O₂, H₂O) adapté au retrait des contaminants métalliques), un nettoyage type "CARO" ou "Piranhaclean" (H₂SO₄:H₂O₂), ou encore un nettoyage avec une solution ozone/eau (O₃/H₂O). Le nettoyage peut être suivi d'un brossage ("scrubber").

Afin d'accroître encore l'énergie de collage, la surface 120a de la deuxième plaque 120 peut être activée par un traitement plasma (étape S2).

La surface 111a de la couche de silicium 111 de la première plaque 110 peut être recouverte d'une couche d'oxyde thermique 114, formée par exemple par oxydation de la surface de la plaque (figure 4B, étape S3).

La surface 111a, recouverte ou non d'une couche d'oxyde, peut également être activée par traitement plasma (étape S4). L'activation des surfaces de collage des substrats 110 et 120 peut être réalisée en exposant celles-ci à un plasma à base d'oxygène, d'azote, d'argon ou autres. Les équipements utilisés à cet effet peuvent entre autres être initialement prévus pour des gravures ioniques réactives RIE (acronyme anglo-saxon de "Reactive Ion Etching") à couplage capacitif, ou à couplage inductif ICP (acronyme anglo-saxon de "Inductively Coupled Plasma"). Pour plus de précisions, on pourra par exemple se référer au document de Sanz-Velasco et Coll. intitulé "Room temperature wafer bonding using oxygen plasma treatment in reactive ion etchers with and without inductively coupled plasma" (Journal of Electrochemical Society 150, G155, 2003).

Ces plasmas peuvent en outre être plongés dans un champ magnétique, notamment pour éviter des diffusions d'espèces électriquement chargées vers les parois du réacteur, grâce à des équipements de type MERIE (acronyme anglo-saxon de "Magnetically Enhanced Reactive Ion Etching").

La densité du plasma peut être choisie faible, moyenne ou forte (ou "HDP" de l'acronyme anglo-saxon "High-Density-Plasma").

Dans la pratique, l'activation de collage par plasma comprend en général au préalable un nettoyage chimique, tel qu'un nettoyage RCA (à savoir la combinaison d'un bain SC1 (NH₄OH, H₂O₂, H₂O) adapté au retrait des particules et des hydrocarbures et d'un bain SC2 (HCl, H₂O₂, H₂O) adapté au retrait des contaminants métalliques), suivi de l'exposition de la surface avec un plasma pendant quelques secondes à quelques minutes.

Un ou plusieurs nettoyages postérieurs à l'exposition plasma peuvent être mis en oeuvre, notamment pour retirer les contaminants introduits lors de l'exposition, tels qu'un rinçage à l'eau et/ou un nettoyage SC1, suivis éventuellement de séchage par centrifugation. Toutefois, ces nettoyages peuvent être remplacés par un brossage permettant d'éliminer une partie importante de ces contaminants.

L'activation d'une surface de collage par traitement plasma est bien connue de l'homme du métier et ne sera pas décrite ici plus en détail par souci de simplification.

Une fois préparées, la surface 111a (ici recouverte de la couche d'oxyde 114) et la surface 120a sont mises en contact intime et une pression est appliquée sur l'une des deux plaques afin d'initier la propagation d'une onde de collage entre les surfaces en contact (étape S5, figure 4C).

Comme bien connu en soi, le principe du collage par adhésion moléculaire, encore appelé collage direct, est basé sur la mise en contact direct de deux surfaces, c'est-à-dire sans l'utilisation d'un matériau spécifique (colle, cire, brasure, etc.). Une telle opération nécessite que les surfaces à coller soient suffisamment lisses, exemptes de particules ou de contamination, et qu'elles soient suffisamment rapprochées pour permettre d'initier un contact, typiquement à une distance inférieure à quelques nanomètres. Dans ce cas, les forces attractives entre les deux surfaces sont assez élevées pour provoquer l'adhérence moléculaire (collage induit par l'ensemble des forces attractives (forces de Van Der Waals) d'interaction électronique entre atomes ou molécules des deux surfaces à coller).

Conformément à l'invention, avant de procéder à un recuit de renforcement de collage, on procède à une étape de détourage au moins partiel de la première plaque, c'est-à-dire au retrait d'une portion annulaire de la première plaque située en périphérie ou en bord de cette dernière et s'étendant sur toute ou partie de l'épaisseur de la première plaque (étape S6, figure 4D).

Comme illustré sur la figure 4D, le détourage est réalisé sur une largeur Id à partir du bord de la première plaque 110. Pour des plaques d'un diamètre de 100 mm, 200 mm, et 300 mm, la largeur Id du détourage est en général comprise entre 2 mm et 10 mm, préférentiellement entre 2 mm et 6 mm.

Le détourage est principalement réalisé par action ou usinage mécanique à partir de la face supérieure de la première plaque 110 (en anglais "edge grinding"). L'action mécanique peut être exercée par une meule ou tout autre outil apte à user mécaniquement le matériau de la couche.

Le détourage peut être "progressif', c'est-à-dire être réalisé au moins en deux étapes, à savoir une première étape de détourage effectuée au plus près du bord de la plaque et une deuxième étape de détourage effectuée à une distance plus éloignée du bord de la première plaque.

En outre, le détourage peut être "mixte", c'est-à-dire comprendre une ou des première(s) étape(s) de détourage par action ou usinage entièrement mécanique (meulage, abrasion, arasage, etc.) mais limitée(s) à une profondeur déterminée dans la première plaque suivie d'une deuxième étape de détourage réalisée avec des moyens au moins partiellement non mécaniques, c'est-à-dire des moyens n'impliquant pas uniquement des frottements mécaniques sur la plaque, tels qu'une gravure chimique, encore appelée gravure humide, une gravure ionique réactive (ou "Reactive Ionic Etching"), encore appelée gravure plasma ou gravure sèche, ou un polissage mécano-chimique (CMP).

Dans le cas des détourages progressifs ou mixtes, on limite les échauffements et/ou les contraintes responsables notamment des phénomènes de macro et micro écaillages en bord de plaques.

Lors du détourage, la première plaque 110 est attaquée sur une profondeur Pd, définie à partir d'un plan de référence correspondant à l'interface de collage (ici le plan de contact entre la couche d'oxyde thermique 114 et la face de collage 120a de la deuxième plaque 120). La profondeur Pd est choisie de manière à enlever en bord de la première plaque toute ou partie de l'épaisseur de cette dernière. Dans l'exemple, décrit ici, la profondeur de détourage Pd est choisie de manière à laisser subsister en bord de la première plaque une portion annulaire 1110 d'une épaisseur réduite e. Conformément à l'invention, l'épaisseur e de la portion annulaire formée après un détourage partielle est inférieure ou égale à 55 µm, épaisseur à partir de laquelle la contrainte de décollement exercée en bord de plaque commence à être significativement réduite.

Après le détourage et avant de procéder à l'amincissement de la première plaque 110, le collage est renforcé en réalisant un recuit dit de renforcement de collage (étape S7). Le recuit de renforcement de collage est réalisé à une température de traitement d'environ 160°C sur une durée d'environ 2 heures. Ce recuit permet de réduire les défauts de type couronne (zone périphérique non transférée) et de prévenir la délamination des deux plaques lors de l'étape d'amincissement.

Lors du recuit de renforcement de collage, la température d'enfournement ("boat-in temperature") de l'assemblage constitué par le collage de la première plaque 110 sur la deuxième plaque 120 est de préférence inférieure à 80°C, par exemple 50°C. Une fois l'assemblage introduit dans le four de recuit, la rampe de montée en température ("temperature ramp up"), c'est-à-dire la vitesse de montée en température utilisée pour amener la température du four depuis la température d'enfournement jusqu'à la température proprement dite du recuit de renforcement de collage, est de préférence de l'ordre de 1°C/min. Un tel contrôle de la température d'enfournement et de la rampe de montée en température permet de réduire les contraintes thermiques appliquées sur l'assemblage lors du recuit.

La réalisation de l'hétérostructure se poursuit par l'amincissement de la première plaque 110 de manière à former une couche transférée correspondant à une portion de ladite première plaque.

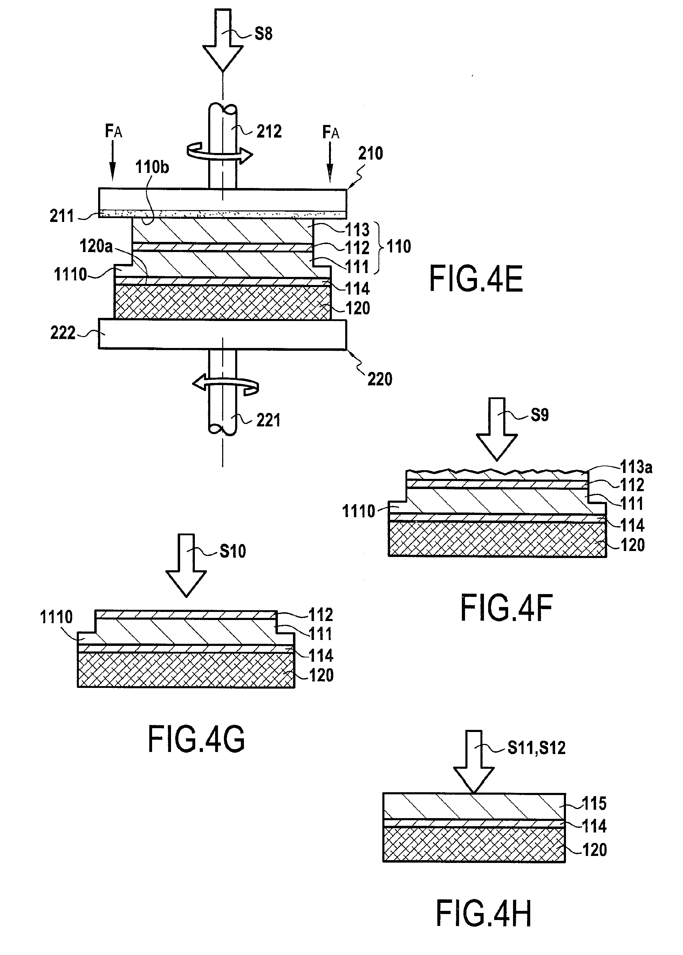

L'amincissement est réalisé d'abord par meulage d'une portion majoritaire du support 113 (étape S8, figure 4E). Conformément à l'invention, le meulage est réalisé avec une roue ou meule 210 dite "grossière", c'est-à-dire une roue dont la surface ou partie active de meulage 211 comporte des particules abrasives d'une taille moyenne supérieure à 6,7 microns (ou 2000 mesh), de préférence supérieure ou égale à 15 microns (ou 1000 mesh), et encore plus préférentiellement supérieure ou égale à 31 microns (ou 500 mesh). Les particules abrasives peuvent être notamment des particules de diamant. A titre d'exemple, la référence d'un modèle de roue commercialisé par la société Saint-Gobain et comportant des particules abrasives type diamant d'une taille moyenne de 6,7 microns (ou 2000 mesh) est: FINE WHEEL STD - 301017:18BB-11-306-B65JP-5MM 11,100x1,197x9,002 MC176261 69014113064 POLISH#33P1,28BX623D-5MM. La référence d'un modèle de roue commercialisé par la société Saint-Gobain et comportant des particules abrasives type diamant d'une taille moyenne de 44 microns (ou 325 mesh) est: COARSE WHEEL STD - 223599 : 18BB-11-32B69S 11,034 X 1-1/8 X 9,001 MD15219669014111620 COARSE #3R7B69 - 1/8.

Lors du meulage, l'assemblage des deux plaques est maintenu au niveau de la face arrière du substrat support 120 par un support 220, également appelé "chuck", comportant un plateau 222 apte à maintenir la deuxième plaque 120, par exemple, par succion ou par un système électrostatique. Durant le meulage, le support 220 peut être fixe tandis que la roue 210 est entraînée en rotation autour de son axe 212. Alternativement, le support 220 peut être aussi mobile en rotation autour d'un axe 221, la roue 210 étant entraînée ou non en rotation.

Le meulage est réalisé en maintenant la surface active de meulage 211 de la roue 210 contre la face exposée 110b de la première plaque 110. Grâce à la taille importante des particules abrasives, le matériau de la première plaque 110 peut être attaqué efficacement sans avoir à appliquer avec la roue 210 une force d'appui F_{A} trop importante sur l'assemblage, ce qui permet de réduire les risques de délamination entre les deux plaques collées. Pour une roue dont la surface ou partie active de meulage comporte des particules abrasives d'une taille moyenne de 6,7 microns (ou 2000 mesh) la force d'appui maximum est d'environ 222,5 newtons (50 lbs). Cette force d'appui maximum diminue avec l'augmentation de la taille des particules abrasives. Par exemple, pour une roue dont la surface ou partie active de meulage comporte des particules abrasives d'une taille moyenne de 44 microns (ou 325 mesh) la force d'appui maximum est d'environ 133,5 newtons (30 lbs).

Le meulage est stoppé à environ 65 µm de la surface 120a du substrat support en saphir.

A ce stade de l'amincissement, c'est-à-dire avant la deuxième étape de l'amincissement réalisée par voie chimique, on peut procéder à un recuit post-meulage (étape S9, figure 4F) afin de renforcer le collage et éviter l'infiltration de la solution de gravure dans l'interface de collage lors de la deuxième étape d'amincissement. En raison de l'utilisation d'une roue ou meule grossière lors du meulage, la partie restante 113a du support 113 présente une surface écrouie (figure 4F) qui est source d'apparition de défauts de type cracks. Afin de prévenir l'apparition de ces défauts, la température du recuit post-meulage est limitée à une température comprise entre 150°C et 170°C. Le recuit post-meulage est réalisé sur une durée comprise entre 30 minutes et 4 heures.

L'amincissement du substrat initial est poursuivi par une gravure de la portion restante 113a (étape S10, figure 4G). Cette portion peut être retirée par gravure chimique, encore appelée gravure humide, par exemple, au moyen d'une solution de gravure TMAH (Tetramethylammonium hydroxide).

La portion restante 113a peut également être enlevée au moyen d'une gravure ionique réactive (ou "Reactive Ionic Etching"), encore appelée gravure plasma ou gravure sèche. Cette technique de gravure est bien connue de l'homme du métier. Pour rappel, il s'agit d'une gravure physico-chimique mettant en jeu à la fois un bombardement ionique et une réaction chimique entre le gaz ionisé et la surface de la plaque ou de la couche à graver. Les atomes du gaz réagissent avec les atomes de la couche ou de la plaque pour former une nouvelle espèce volatile qui est évacuée par un dispositif de pompage.

La couche d'oxyde 112 est utilisée comme couche d'arrêt pour la gravure. Après la gravure, la couche 112 peut être retirée (étape S11, figure 4H), par exemple par désoxydation HF, de manière à laisser subsister une couche transférée 115 correspondant à au moins une partie de la couche de silicium 111. Toutefois, selon les besoins, la couche d'oxyde 112 peut être conservée.

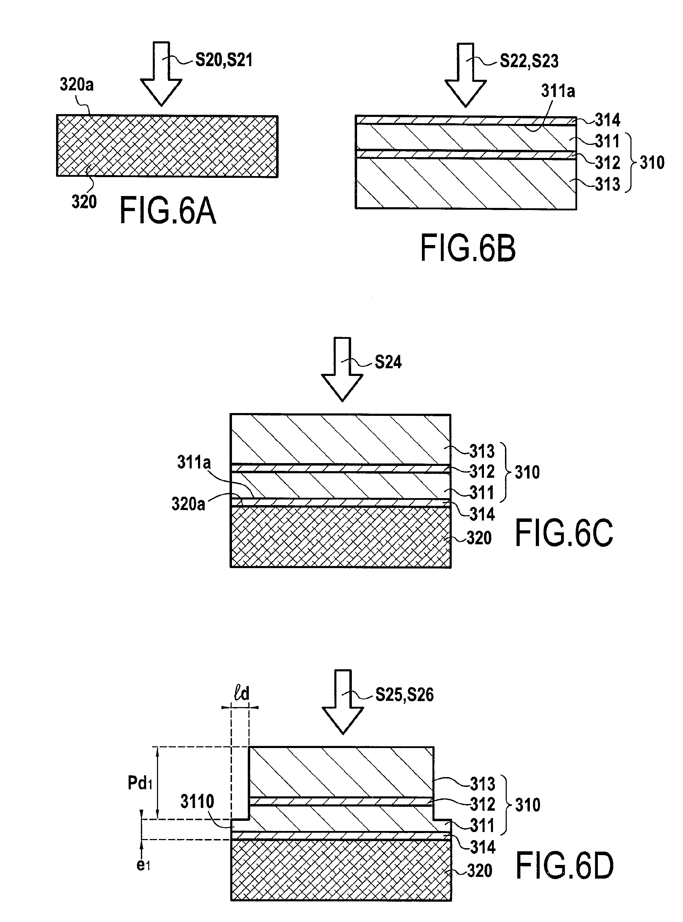

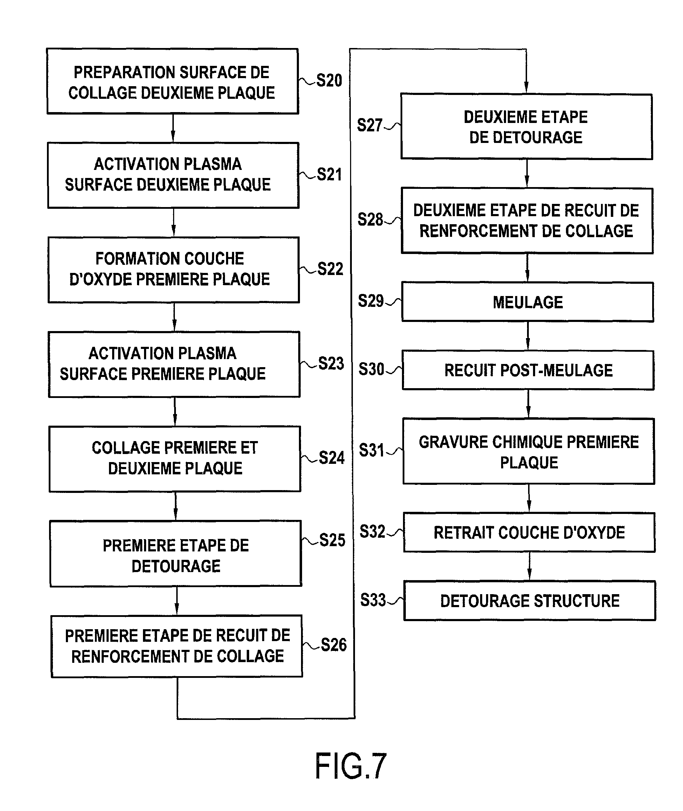

On décrit maintenant en référence aux figures 6A à 6I et 7, un autre mode de mise en oeuvre du procédé de l'invention qui diffère de celui précédemment décrit en relation avec les figures 4A à 4H et 5 en ce que le détourage de la première plaque et en ce que le recuit de renforcement de collage sont chacun réalisés en deux étapes.

De même que décrit ci-avant, on utilise une première plaque 210 constituée d'une structure de type SOI (Silicium sur Isolant) comprenant une couche de silicium 311 sur un support 313 également en silicium, une couche d'oxyde enterrée 312 étant disposée entre la couche 311 et le support 313 (figure 6B), et une deuxième plaque 320 constituée d'une plaque ("wafer") de saphir (figure 6A).

Avant de procéder au collage des plaques, la surface de collage 320a de la deuxième plaque 320 peut être préparée (étape S20) et activée par traitement plasma (étape S21) tandis que la surface 311a de la couche de silicium 311 de la première plaque 310 peut être recouverte d'une couche d'oxyde thermique 314 (figure 6B, étape S22) et être activée par traitement plasma (étape S23), ces traitements étant réalisées suivant les mêmes conditions que décrites ci-avant.

Les première et deuxième plaques 310 et 320 sont ensuite collées par mise en contact intime de la surface 311a (ici recouverte de la couche d'oxyde 314) avec la surface 320a et application d'une pression sur l'une des deux plaques afin d'initier la propagation d'une onde de collage entre les surfaces en contact (étape S24, figure 6C).

Le détourage débute par une première étape de détourage réalisée sur une largeur Id et sur une profondeur Pd₁ dans la première plaque 310 de manière à laisser subsister en bord de la première plaque une portion annulaire 3110 d'une épaisseur réduite e₁ (étape S25, figure 6D). L'épaisseur e₁ de la portion annulaire formée après ce premier détourage est de préférence inférieure ou égale à 50 µm, épaisseur à partir de laquelle la contrainte de décollement exercée en bord de plaque commence à être significativement réduite.

Après cette première étape de détourage, on procède à une première étape de recuit de renforcement de collage (étape S26). Le détourage de la première plaque 310 n'étant pour l'instant que partiellement réalisé, cette première étape de recuit de renforcement de collage est réalisée à une température modérée. La température de ce premier recuit est en fonction de l'épaisseur e₁ résultante de la portion annulaire 3110 après la première étape de détourage. Plus cette épaisseur est faible, plus la température de la première étape de recuit peut être élevée. Cette première étape de recuit peut être réalisée à une température comprise entre 180°C et 200°C et sur durée comprise entre 30 minutes et 4 heures.

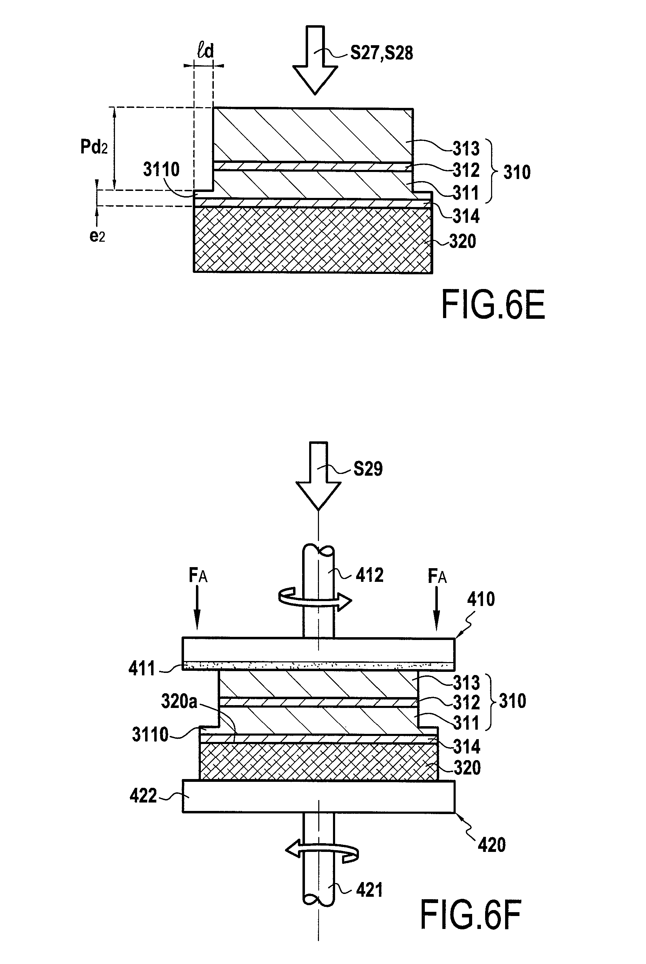

Le détourage de la première plaque 310 est ensuite complété par une deuxième étape de détourage réalisée sur une profondeur Pd₂ dans la première plaque 310 de manière à réduire encore l'épaisseur de la portion annulaire 3110 à une deuxième épaisseur e₂ (étape S27, figure 6E). L'interface de collage entre les première et deuxième plaques ayant été déjà renforcée par le premier recuit de renforcement de collage, la deuxième étape de détourage peut être réalisée sur une profondeur Pd₂ importante sans risque d'endommagement de l'assemblage. L'épaisseur e₂ de la portion annulaire 3110 après la deuxième étape de détourage peut être notamment inférieure ou égale 45 µm, voire nulle.

Une deuxième étape de recuit de renforcement de collage est alors réalisée (étape S28). Cette deuxième étape de recuit peut être réalisée à une température supérieure à celle du premier recuit car les contraintes de décollement en bord de plaques sont considérablement réduites par la deuxième étape de détourage. Cette deuxième étape de recuit peut être réalisée à une température comprise entre 200°C et 250°C et sur durée comprise entre 30 minutes et 4 heures.

Les première et deuxième étapes de détourage peuvent être chacune réalisées par détourage mécanique continu, par détourage progressif ou par détourage mixte.

On procède ensuite à l'amincissement de la première plaque 110 de manière à former une couche transférée correspondant à une portion de ladite première plaque. L'amincissement est réalisé d'abord par meulage d'une portion majoritaire du support 313 (étape S29, figure 6F). De même que décrit précédemment, le meulage est réalisé avec une roue ou meule 410 dite "grossière", c'est-à-dire une roue dont la surface ou partie active de meulage 411 comporte des particules abrasives d'une taille moyenne supérieure à 6,7 microns (ou 2000 mesh), de préférence supérieure ou égale à 15 microns (ou 1000 mesh), et encore plus préférentiellement supérieure ou égale à 31 microns (ou 500 mesh). L'assemblage des deux plaques est maintenu au niveau de la face arrière du substrat support 320 par un support 420, également appelé "chuck", comportant un plateau 422 apte à maintenir la deuxième plaque 320, par exemple, par succion ou par un système électrostatique. Durant le meulage, le support 420 peut être fixe tandis que la roue 410 est entraînée en rotation autour de son axe 412. Alternativement, le support 420 peut être aussi mobile en rotation autour d'un axe 421, la roue 410 étant entraînée ou non en rotation.

Grâce à la taille importante des particules abrasives, le matériau de la première plaque 310 peut être attaqué efficacement sans avoir à appliquer avec la roue 410 une force d'appui F_{A} trop importante sur l'assemblage, ce qui permet de réduire les risques de délamination entre les deux plaques collées. Le meulage est stoppé à environ 120 µm de la surface 320a du substrat support en saphir.

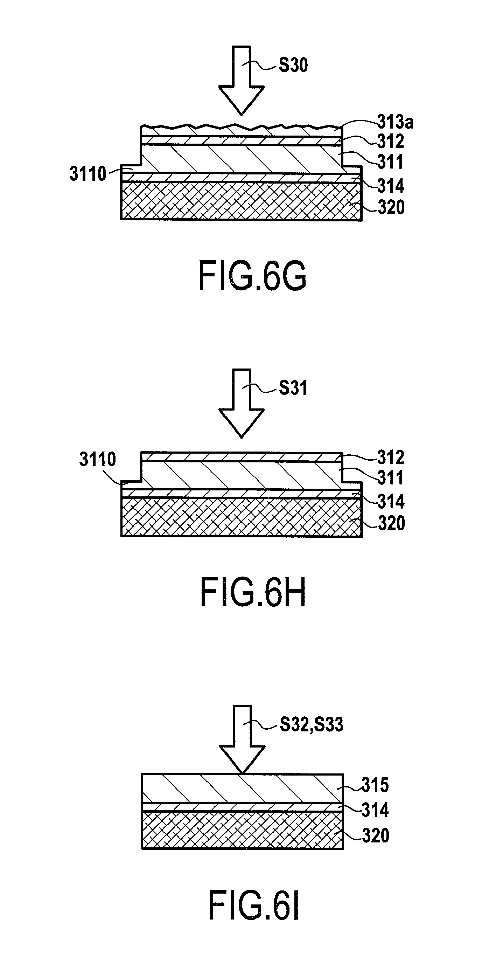

Avant la deuxième étape de l'amincissement réalisée par voie chimique, on peut procéder à un recuit post-meulage (étape S30, figure 6G) afin de renforcer le collage et éviter l'infiltration de la solution de gravure dans l'interface de collage lors de la deuxième étape d'amincissement. En raison de l'utilisation d'une roue ou meule grossière lors du meulage, la partie restante 313a du support 313 présente une surface écrouie (figure 6G) qui est source d'apparition de défauts de type cracks. Afin de prévenir l'apparition de ces défauts, la température du recuit post-meulage est limitée à une température comprise entre 150°C et 170°C. Le recuit post-meulage est réalisé sur une durée comprise entre 30 minutes et 4 heures.

L'amincissement du substrat initial est poursuivi par une gravure de la portion restante 313a (étape S31, figure 6H). Cette portion peut être retirée par gravure chimique, encore appelée gravure humide, par exemple, au moyen d'une solution de gravure TMAH (Tetramethylammonium hydroxide). La portion restante 313a peut également être enlevée au moyen d'une gravure ionique réactive (ou "Reactive Ionic Etching").

La couche d'oxyde 312 est utilisée comme couche d'arrêt pour la gravure. Après la gravure, la couche 312 peut être retirée (étape S32, figure 6I), par exemple par désoxydation HF, de manière à laisser subsister une couche transférée 315 correspondant à au moins une partie de la couche de silicium 311. Toutefois, selon les besoins, la couche d'oxyde 312 peut être conservée.

Ce mode de mise en oeuvre du procédé de l'invention est notamment avantageux dans les cas où la profondeur de détourage visée ne peut être atteinte directement en une seule étape sans risque d'endommagement de l'assemblage. Ce mode de mise en oeuvre permet notamment d'éviter les problèmes d'écaillage qui, lors d'un détourage profond sur un assemblage avec une interface de collage faible, entraînent une délamination d'une ou des deux plaques sur certaines zones au voisinage de la périphérie de celles-ci et qui peut être qualifiée de macro écaillage (ou "macro peel off").

## Revendications

1. Procédé de réalisation d'une hétérostructure comprenant une étape de collage d'une première plaque (110) sur une deuxième plaque (120), la première plaque (110) ayant un coefficient de dilatation thermique inférieur au coefficient de dilatation thermique de la deuxième plaque (120) et au moins une étape de recuit de renforcement de collage,
**caractérisé en ce que** le procédé comprend, après l'étape de collage et avant ladite au moins une étape de recuit de renforcement de collage, au moins une étape de détourage au moins partiel de la première plaque (110).

2. Procédé selon la revendication 1, **caractérisé en ce que**, après ladite au moins une étape de détourage, la première plaque (110) présente au niveau sa portion détourée (1110) une épaisseur inférieure ou égale à 55 µm.

3. Procédé selon la revendication 1 ou 2, **caractérisé en ce que** ladite au moins une étape de recuit de renforcement de collage est réalisée à une température d'environ 160°C sur une durée d'environ 2 heures.

4. Procédé selon la revendication 1, **caractérisé en ce qu**'il comprend des première et deuxième étapes de recuit de renforcement de collage et des première et deuxième étapes de détourage au moins partiel de la première plaque, et en ce que la première étape de détourage est réalisée après ladite première étape de recuit et avant ladite deuxième étape de recuit, tandis que la deuxième étape de détourage est réalisée après ladite deuxième étape de recuit.

5. Procédé selon la revendication 4, **caractérisé en ce que** la deuxième étape de recuit de renforcement de collage est réalisée à une température supérieure à celle de la première étape de recuit de renforcement de collage.

6. Procédé selon l'une quelconque des revendications 1 à 5, **caractérisé en ce que** la première plaque (110) est un substrat de silicium ou un substrat SOI.

7. Procédé selon l'une quelconque des revendications 1 à 6, **caractérisé en ce que** la deuxième plaque (120) est un substrat de saphir.

8. Procédé selon la revendication 7, **caractérisé en ce qu**'il comprend en outre, après la ou les étapes de recuit de renforcement de collage, une étape d'amincissement de la première plaque (110), l'amincissement étant réalisé par meulage suivi d'une gravure de la première plaque.

9. Procédé selon la revendication 8, **caractérisé en ce que** le meulage est réalisé avec une roue dont la surface de travail comprend des particules abrasives d'une taille moyenne supérieure à 6,7 microns.

10. Procédé selon l'une quelconque des revendications 1 à 9, **caractérisé en ce que**, lors du ou des recuits de renforcement de collage, la température d'enfournement de l'hétérostructure est inférieure à 80°C.

11. Procédé selon l'une quelconque des revendications 1 à 9, **caractérisé en ce que**, lors du ou des recuits de renforcement de collage, la rampe de montée en température est de l'ordre de 1°C/min.

12. Procédé selon l'une quelconque des revendications 1 à 11, **caractérisé en ce qu**'il comprend, avant le collage des deux plaques (110, 120), la formation d'une couche d'oxyde (114) sur la surface de collage de la première plaque (110).

13. Procédé selon l'une quelconque des revendications 1 à 12, **caractérisé en ce qu**'il comprend, avant le collage des deux plaques (110, 120), une étape d'activation de la surface de collage d'au moins une des deux plaques.

14. Procédé selon l'une quelconque des revendications 9 à 13, **caractérisé en ce que**, lors du meulage, la force d'appui de la roue sur la première plaque n'excède pas 222,5 newtons.
